# EUROPEAN PATENT APPLICATION

(11) **EP 1 401 138 A1**
(43) Date of publication of application: **24.03.2004**
(21) Application number: 03710415.5
(22) Date of filing: 19.03.2003
(51) Int. Cl.: H04L 1/00, H03M 13/35, H03M 13/45

(54) **ERROR CORRECTION/DECODING DEVICE AND ERROR CORRECTION/DECODING METHOD**

(30) Priority: 29.03.2002 JP 2002097969
(71) Applicant: MATSUSHITA ELECTRIC INDUSTRIAL CO., LTD., Kadoma-shi, Osaka 571-8501 (JP)
(72) Inventor: TAMESUE, Kazuhiko, Yokosuka-shi, Kanagawa 239-0833 (JP); KANAI, Hirokazu, Yokosuka-shi, Kanagawa 239-0833 (JP)
(74) Representative: Grünecker, Kinkeldey, Stockmair & Schwanhäusser Anwaltssozietät
(86) International application number: PCT/JP2003/003291
(87) International publication number: WO 2003/084114

(57) **Abstract**

An error correction decoding apparatus and error correction decoding method which reduces a processing delay time, reduces omission errors and thereby improves transmission quality. The turbo decoder (610) receives coding sequence x, coding sequence y1 and coding sequence y2 as inputs and outputs a decoding result. Furthermore, the turbo decoder (610) performs iterative decoding according to a control signal output from the decoding control section (630). The error detector (620) receives the decoding result and performs error detection for each transport block. The decoding control section (630) decides whether or not to preform iterative decoding based on the detection result and the number of transport blocks.

## Description

### Technical Field

The present invention relates to an error correction decoding apparatus and error correction decoding method, and more particularly, to an error correction decoding apparatus and error correction decoding method which performs iterative decoding.

### Background Art

When a radio communication system carries out a digital communication, data errors may occur in a transmission path due to disturbances such as noise and fading. To cope with such data errors, the receiving side performs ARQ (Automatic Repeat reQuest) or FEC (Forward Error Correction) which are well known error control technologies. ARQ is a technology for improving communication reliability by detecting bit errors generated in an information sequence through error detection and by retransmitting an erroneous information block. On the other hand, FEC is a technology for improving communication reliability by correcting bit errors generated in an information sequence through error correction. FEC is effective for a system which is provided with no feedback channel for requesting retransmissions or a system for which no delay by retransmission is allowed.

As one of conventional channel coding techniques using FEC, a convolutional code is known. Channel coding adds a redundant bit which is an error detection code bit or error correction code bit to information to be transmitted. For example, a CRC (Cyclic Redundancy Check) code is available as an error detection code. Coded information is decoded on the receiving side and errors are detected and corrected by a redundant bit.

One of such channel coding methods is a turbo code which is becoming a focus of attention in recent years as a code which approaches a Shannon limit. The turbo code is described in documents such as "Near Optimum Error Correcting Coding And Decoding: Turbo-Codes (IEEE Transactions, Vol.44, No.10, October 1996)", [A tutorial on "parallel concatenated (Turbo) coding", "Turbo (iterative) decoding" and related topics (TECHNICAL REPORT OF IEICE.IT98-51 (1998-12))], and "Performance of Turbo codes applied to W-CDMA (TECHNICAL REPORT OF IEICE. SST97-77, SANE97-102 (1997-12))", etc.

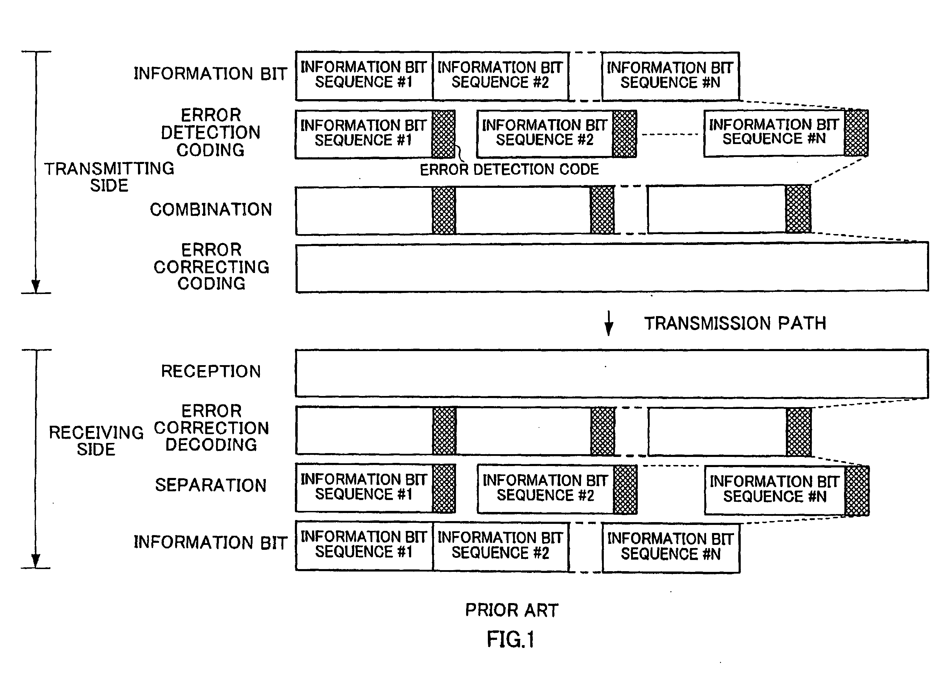

As described in these documents, turbo coding can be realized by concatenating a plurality of recursively organized convolutional coders which are provided on the transmitting side in parallel through an interleaver. At this time, a physical channel which transmits an information sequence combines transport blocks subjected to error detection coding and carries out error correction coding on the combined plurality of transport blocks as shown in FIG.1.

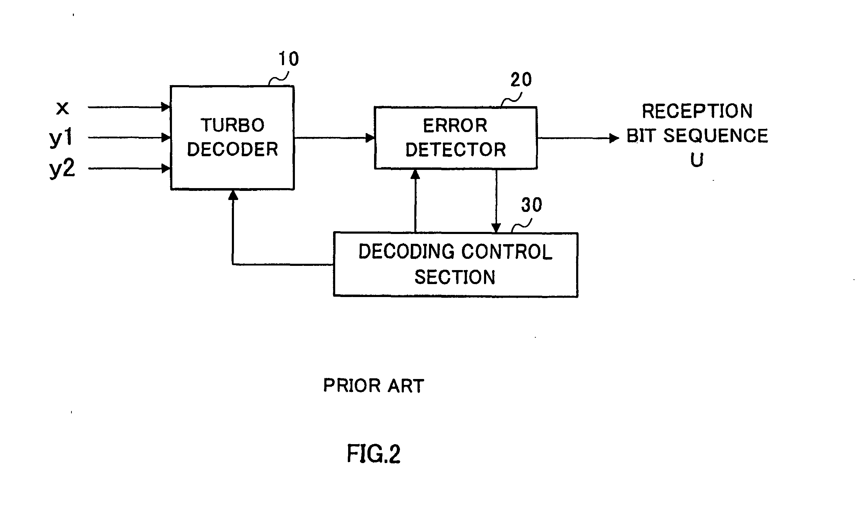

Furthermore, turbo decoding is carried out by a decoding section on the receiving side as shown in FIG.2. A turbo decoder 10 iterates error correction decoding on a plurality of turbo coded coding sequences (that is, iterative decoding) and an error detector 20 performs error detection. The detection result is output to a decoding control section 30 and the decoding control section 30 decides whether iterative decoding should be continued or not. At this time if the detection result shows no error, the error detector 20 outputs a reception bit sequence. On the other hand, if the detection result shows some errors, the turbo decoder 10 performs iterative decoding until a maximum iteration count is reached. In a turbo decoding operation, a BER (Bit Error Rate) characteristic with respect to an SNR (Signal to Noise Ratio) improves every time iterative decoding is carried out.

The above described turbo decoding has a problem that as the iterative decoding count increases, a processing delay required for decoding processing increases and power consumption increases. To solve this problem, technologies for optimizing stop control of an iterative decoding count are disclosed in the Unexamined Japanese Patent Publication No.2000-183758 and National Publication of International Patent Application No.2000-513555, etc. The former decides continuation of iterative decoding according to a decoding result and the latter decides an iteration count of iterative decoding according to required quality such as a bit error rate and allowable delay time, etc. These technologies can do without unnecessary iterative decoding while securing desired transmission quality and thereby suppress a processing delay time and reduce power consumption.

However, the above described method has a problem that even if an error remains in the decoding result, the error detection result may happen to show no errors, resulting in an omission error whereby decoding is terminated with remaining errors. An omission error results in a problem that a checksum error, etc., may occur in a higher layer such as TCP (Transmission Control Protocol), a packet may be discarded and a transmission loss occurs.

### Disclosure of Invention

It is an object of the present invention to reduce a processing delay time, reduce omission errors and thereby improve transmission quality.

The subject matter of the present invention is to change a method of controlling an iterative decoding count according to the number of transport blocks which are blocks subjected to error detection coding.

An error correction decoding apparatus according to an embodiment of the present invention comprises an iterative decoding section that iterates error correction decoding on a coded sequence subjected to error correction coding for predetermined transmission unit to which an error detection code is added, an error detection section that performs error detection on the error correction decoding result for every said predetermined transmission unit according to said error detection code; and an iteration control section that controls said iterative decoding section based on the number of said predetermined transmission units and the detection result of said error detection section.

According to another embodiment of the present invention, the error correction decoding method is An error correction decoding method for iterating error correction decoding on a coded sequence subj ected to error correction coding for predetermined transmission unit to which an error detection code is added, comprising: a step of performing error detection on the error correction decoding result for every said predetermined transmission unit according to said error detection code; and a step of controlling iteration of error correction decoding based on the number of said predetermined transmission units and error detection result.

### Brief Description of Drawings

FIG.1 illustrates a flow of error decoding processing on an information bit sequence subjected to error detection coding and error correction coding;
FIG.2 is a block diagram showing a configuration of a conventional decoding section;
FIG.3 is a block diagram showing a configuration of a radio communication system according to Embodiment 1 of the present invention;
FIG.4 is a block diagram showing a configuration of a coding section according to Embodiment 1;
FIG.5 is a block diagram showing a configuration of a decoding section according to Embodiment 1;
FIG.6 is a flow chart showing an operation of the decoding control section according to Embodiment 1;
FIG.7A illustrates an iterative decoding stop decision method according to Embodiment 1 when the number of transport blocks is one;
FIG. 7B illustrates another iterative decoding stop decision method according to Embodiment 1 when the number of transport blocks is one;
FIG.8 illustrates an iterative decoding stop decision method according to Embodiments when the number of transport blocks is more than one;
FIG.9 illustrates another iterative decoding stop decision method according to Embodiments when the number of transport blocks is more than one;
FIG.10A illustrates a further iterative decoding stop decision method according to Embodiments when the number of transport blocks is more than one;
FIG.10B is a continuation of FIG.10A;
FIG.11 is a flow chart showing an operation of a decoding control section according to Embodiment 2 of the present invention;
FIG.12 illustrates a further iterative decoding stop decision method according to Embodiments when the number of transport blocks is more than one;
FIG.13 illustrates a further iterative decoding stop decision method according to Embodiments when the number of transport blocks is more than one; and
FIG.14 is a flow chart showing an operation of a decoding control section according to Embodiment 3 of the present invention.

### Best Mode for Carrying out the Invention

With reference now to the attached drawings, embodiments of the present invention will be explained in detail below.

### (Embodiment 1)

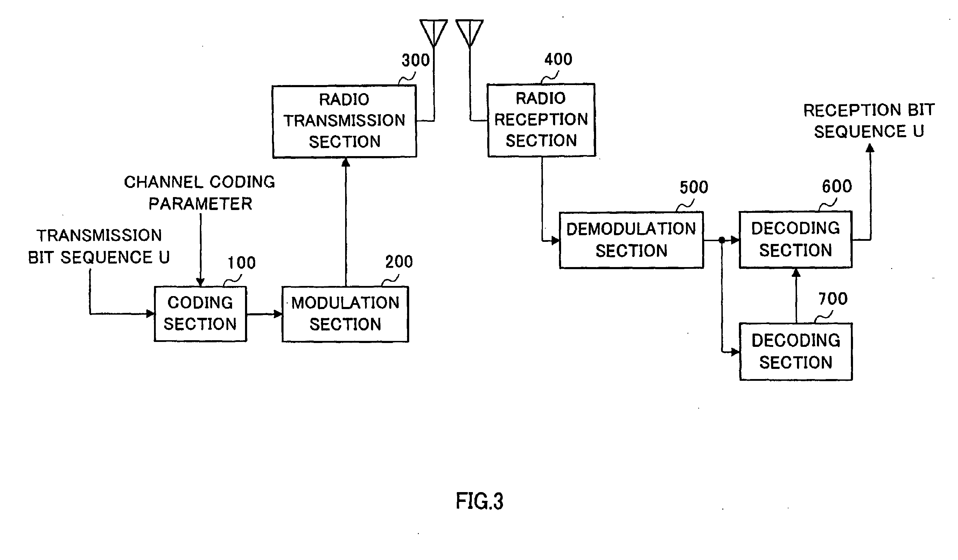

FIG.3 is a block diagram showing a configuration of a radio communication system according to Embodiment 1 of the present invention.

The radio communication system shown in FIG.3 comprises a coding section 100, a modulation section 200, a radio transmission section 300, a radio reception section 400, a demodulation section 500, a decoding section 600 and a decoding section 700.

First, a transmission bit sequence U and channel coding parameter are input to the coding section 100. The channel coding parameter refers to the number of transport blocks, that is, the number of codes subjected to error detection coding included in one sequence subjected to error correction coding. The coding section 100 carries out error detection coding and error correction coding of transmission signal based on the channel coding parameter. Furthermore, the coding section 100 performs information bit error detection coding and error correction coding. Furthermore, the channel coding parameter including the number of transport blocks is coded by the coding section 100 as a transport format. Both the error correction coded sequence output from the coding section 100 and the number of separately coded transport blocks (transport format) are modulated by the modulation section 200, and further radiated out into space by the radio transmission section 300 through an antenna. The radiated signal is received by the radio reception section 400 through an antenna, demodulated by the demodulation section 500 and a coding sequence and transport format are obtained. The transport format is input to the decoding section 700, the number of transport blocks is obtained and the number of transport blocks obtained is output to the decoding section 600. On the other hand, the coding sequence is input to the decoding section 600, subjected to turbo decoding iterative control in consideration of the number of transport blocks and a reception bit sequence U is obtained.

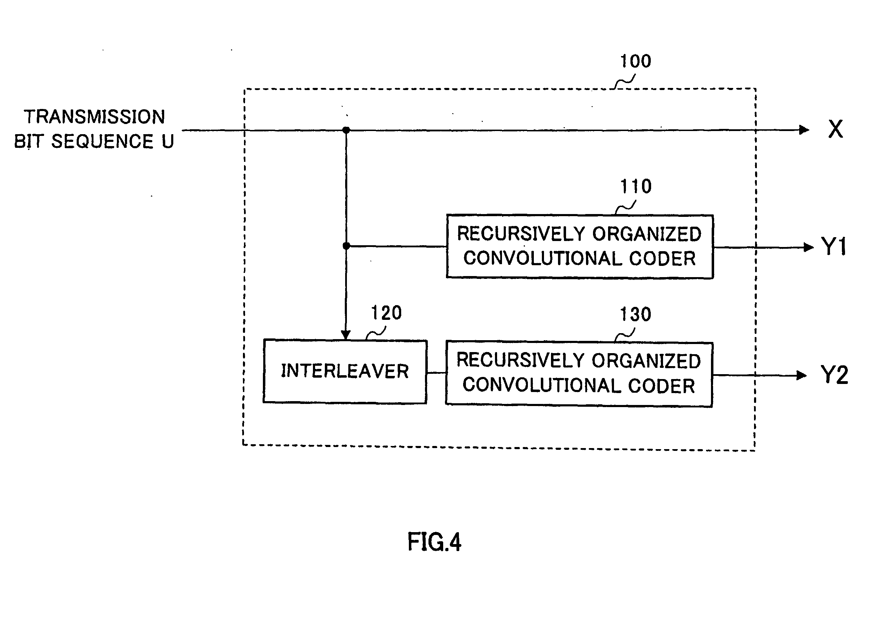

FIG.4 is a block diagram showing an example of a configuration of the coding section 100.

The coding section 100 shown in FIG.4 shows a turbo coder having a code rate of 1/3. The coding section 100 consists of a recursively organized convolutional coder 110, an interleaver 120 and a recursively organized convolutional coder 130. The transmission bit sequence U is divided into 3 sequences, a first sequence becomes a coding sequence X whose input information bit is not changed at all, a second sequence is subjected to convolutional coding by the recursively organized convolutional coder 110 to become a coding sequence Y1 and a third sequence is interleaved by the interleaver 120 and then subjected to convolutional coding by the recursively organized convolutional coder 130 to become a coding sequence Y2 and output.

These coding sequences are transmitted by the radio transmission section 300 through the antenna, disturbance such as noise and fading, etc., added on the transmission path and received by the radio reception section 400 as a coding sequence x, coding sequence y1 and coding sequence y2 through the antenna.

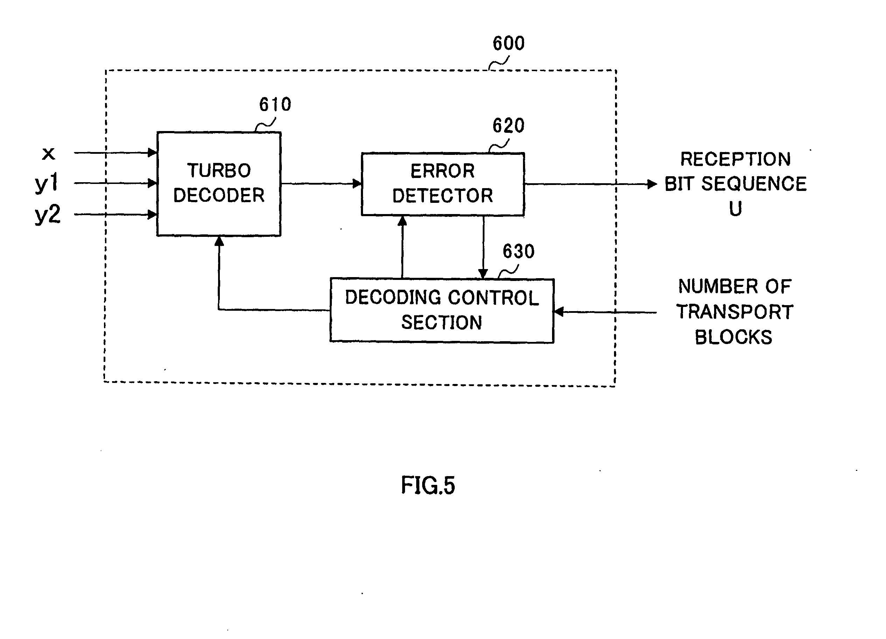

FIG.5 is a block diagram showing an example of a configuration of the decoding section 600.

The decoding section 600 shown in FIG.5 consists of a turbo decoder 610, an error detector 620 and a decoding control section 630. The turbo decoder 610 receives the coding sequence x, coding sequence y1 and coding sequence y2 as inputs and outputs the decoding result. Furthermore, the turbo decoder 610 performs iterative decoding according to a control signal output from the decoding control section 630. The turbo decoder 610 can improve BER (Bit Error Rate) of the decoding result every time iterative decoding is performed. The error detector 620 receives the decoding result and performs error detection for every transport block. The decoding control section 630 decides whether iterative decoding should be performed or not based on the detection result and the number of transport blocks. This decision method will be described later. When the decision result shows that iterative decoding should be performed, the decoding control section 630 outputs a control signal indicating that intention to the turbo decoder 610. Then, the turbo decoder 610 performs an iteration operation of control decoding within a range until a maximum iteration count is reached. Furthermore, when the detection result by the error detector 620 shows no errors, the decoding control section 630 outputs an output enable signal to the error detector 620 and a reception bit sequence U is output from the error detector 620. Here, as a soft decision input - soft decision output decoder (SISO decoder) constituting the turbo decoder 610, a MAP (Maximum a posteriori Probability) decoder or SOVA (Soft Output Viterbi Algorithm), etc., can be used.

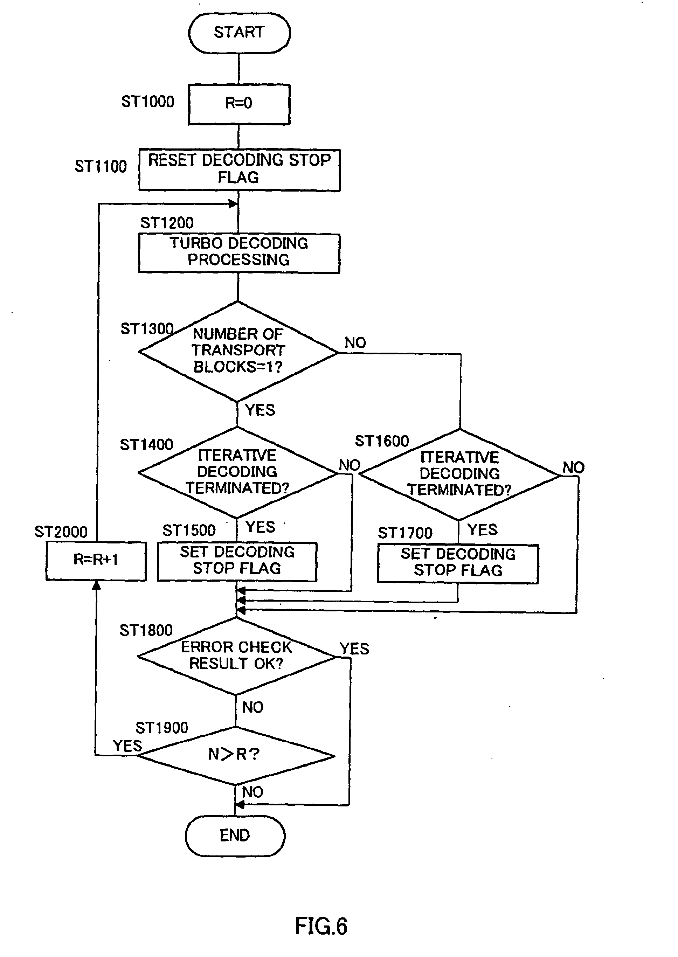

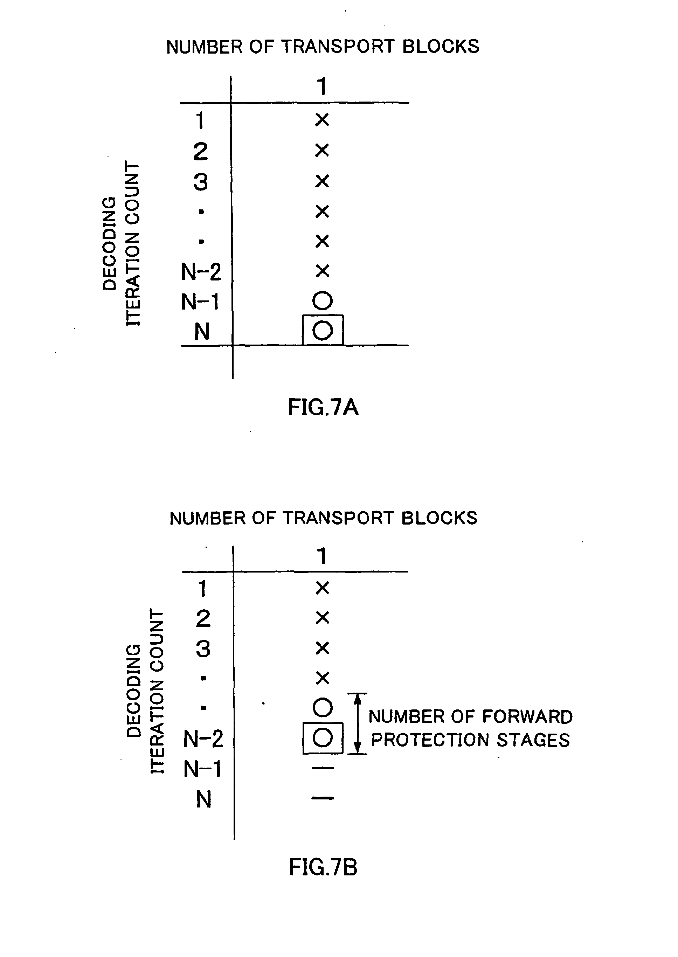

Then, the decision method of the decoding control section 630 will be explained with reference to the flow chart shown in FIG. 6 and FIG.7 to FIG.10. The processing shown in FIG.6 is carried out at a W-CDMA scheme TTI (Transmit Time Interval) specified as 10 ms, 20 ms, 40 ms and 80 ms according to the 3GPP, for example. Furthermore, in FIG.7 to FIG.10, ○ indicates that the result of the error detector 620 shows no errors and × indicates that the result of the error detector 620 shows an error.

As shown in FIG.6, first, a counter R showing a decoding iteration count is initialized to 0 (ST1000) and a decoding stop flag for stopping iterative decoding by the turbo decoder 610 is reset (ST1100).

Then, the decoding control section 630 outputs an instruction for performing decoding processing to the turbo decoder 610 (ST1200). Then, it is decided whether the number of transport blocks is one or not (ST1300) and if the number of transport blocks is one, it is decided whether iterative decoding should be terminated by a predetermined stop decision method or not (ST1400). When the number of transport blocks is one, if iterative decoding is stopped unconditionally based on only the detection result of the error detector 620, an error detection bit may happen to be decided as having no errors in a relatively initial stage of iteration, resulting in omission errors, but this is the processing to suppress these omission errors.

Irrespective of whether the number of transport blocks is one or more than one, the turbo decoder 610 performs error correction decoding on each transport block every time decoding processing is repeated. Furthermore, irrespective of whether the number of transport blocks is one or more than one, the error detector 620 performs error detection of each transport block every time decoding processing is repeated.

When the number of transport blocks is one, either one of the following iterative decoding stop decision methods is used:
(Stop decision method 1): Iterative decoding is terminated when the value of the counter R is equal to a predetermined maximum iteration count N (see FIG.7A).
(Stop decision method 2): The detection result of the error detector 620 is controlled and iterative decoding is terminated when detection results continue to show no errors the same number of times as the number of forward protection stages (see FIG.7B).

Then, when iterative decoding is terminated, a decoding stop flag is set (ST1500) and if iterative decoding is not terminated, the process moves on to the next step. Then, it is decided whether the error detection result of the decoding result matches the termination condition or not (ST1800) and if the decoding stop flag is set, the processing is terminated. When the error detection result of the decoding result does not match the termination condition, a maximum iteration count N is compared with the counter R (ST1900) and the processing is terminated if the counter R reaches the maximum iteration count N, whereas the counter R is incremented (ST2000) if the counter R does not reach the maximum iteration count N, and turbo decoding processing is carried out again.

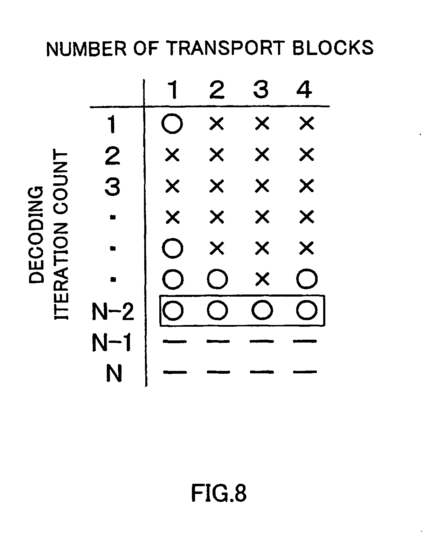

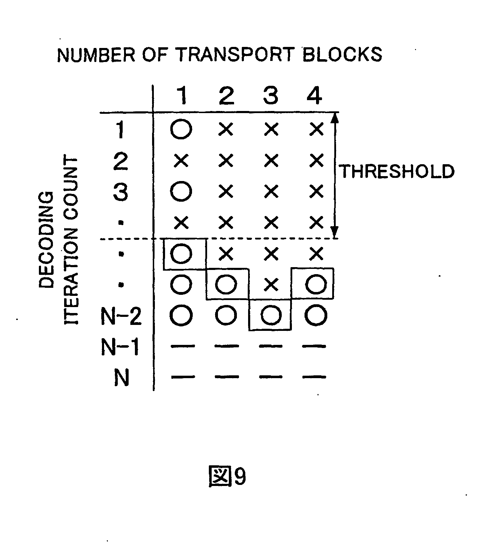

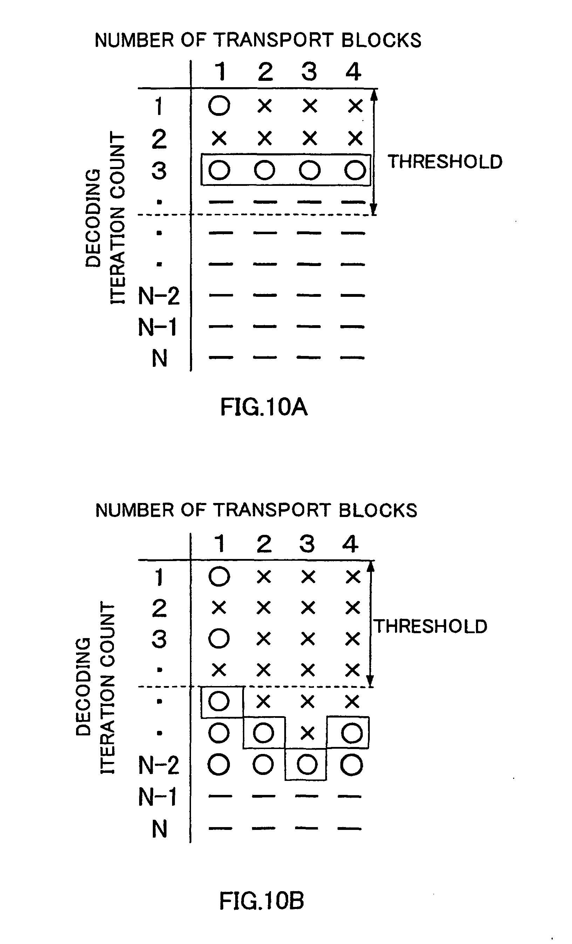

On the other hand, in ST1300, when the number of transport blocks is not one, it is decided by a predetermined stop decision method whether iterative decoding should be terminated or not (ST1600). When the number of transport blocks is not one, any one of the following iterative decoding stop decision methods is used:
(Stop decision method 3): An iterative decoding operation is carried out within the range of a predetermined maximum iteration count and iterative decoding is terminated when error detection results of all transport blocks show no errors simultaneously (see FIG.8).
(Stop decision method 4): An iterative decoding operation is carried out within the range of a predetermined maximum iteration count and iterative decoding is terminated when error detection results of all transport blocks show no errors at least once at an iteration count which is equal to or greater than a predetermined threshold (see FIG.9).
(Stop decision method 5): An iterative decoding operation is carried out within the range of a predetermined maximum iteration count and iterative decoding is terminated when error detection results of all transport blocks show no errors simultaneously (see FIG.10A) or when error detection results of all transport blocks show no errors at least once at an iteration count which is equal to or less than a predetermined threshold (see FIG.10B).

The (stop decision method 5) provides a threshold for defining a count as an "iteration initial stage" and performs the operation of the (stop decision method 3) when the decoding iteration count is equal to or less than a threshold and performs the operation of the (stop decision method 4) when the decoding iteration count is equal to or greater than the threshold. The (stop decision method 5) applies the (stop decision method 3) to decoding when the number of transmission errors is relatively small and applies the (stop decision method 4) to decoding when the number of transmission errors is relatively large, and can thereby suppress omission errors and increase the efficiency of the iteration count.

Then, when iterative decoding is terminated, a decoding stop flag is set (ST1700) and when iterative decoding is not terminated, the process moves on to the next step. The same processing as the case where the number of transport blocks is one will be carried out thereafter.

Thus, this embodiment changes the iterative decoding stop decision method depending on the number of transport blocks and applies different types of decoding iteration operation processing when the number of transport blocks is one and when the number of transport blocks is more than one, and can thereby increase only the iterative decoding count when the number of transport blocks is one, adopt the detection result showing no errors at a count in and after a predetermined threshold with the error detection result for every iterative decoding or adopt the detection result when detection results continue to show no errors aplurality of times with respect to the error detection result, and thereby reduce omission errors by accidental match of error detection bits at the initial stage of decoding iteration.

### (Embodiment 2)

A feature of Embodiment 2 of the present invention is that when there are many transport blocks, if error detection results show only a small number of transport blocks with no errors, all transport blocks are regarded as including errors.

The configuration of the decoding section of this embodiment is the same as the configuration of the decoding section 600 shown in FIG.5 and explanations thereof will be omitted.

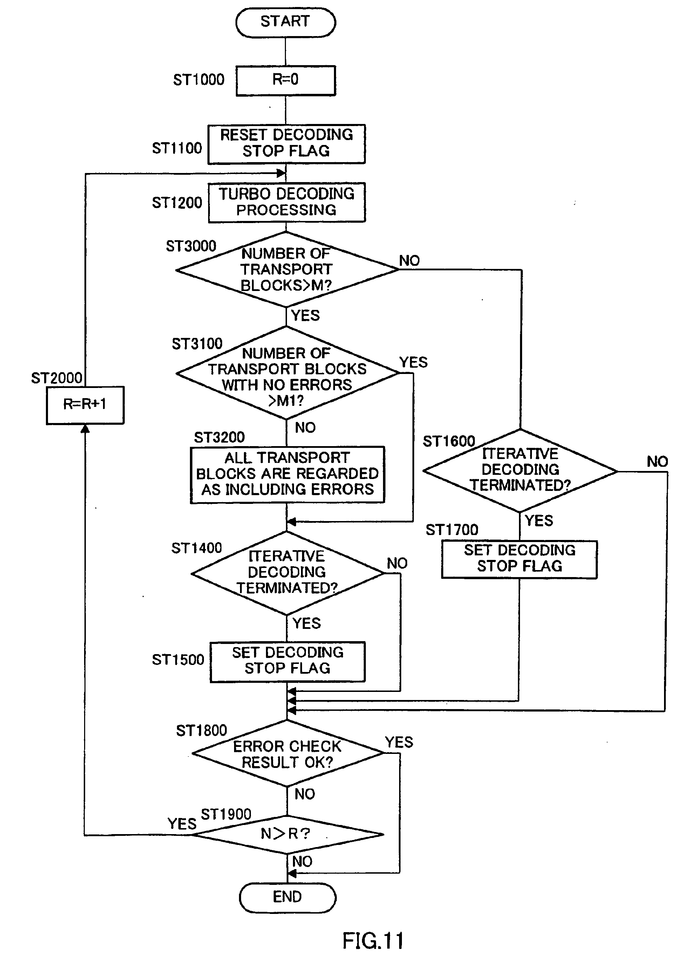

Then, a decision method of the decoding control section 630 will be explained with reference to the flow chart shown in FIG.11 and FIG.8 to FIG.10 and FIG.12 and FIG.13. The processing shown in FIG.11 is carried out at a W-CDMA scheme TTI (Transmit Time Interval) specified as 10 ms, 20 ms, 40 ms and 80 ms according to the 3GPP, for example. Furthermore, in FIG.8 to FIG.10 and FIG.12 and FIG.13, ○ indicates that the result of the error detector 620 shows no errors and × indicates that the result of the error detector 620 shows an error.

As shown in FIG.11, first, a counter R indicating a decoding iteration count is initialized to 0 (ST1000) and a decoding stop flag for stopping iterative decoding by the turbo decoder 610 is reset (ST1100).

Then, the decoding control section 630 outputs an instruction for performing decoding processing to the turbo decoder 610 (ST1200). Then, it is decided whether the number of transport blocks is greater than a predetermined thresholdM or not (ST3000) and if the number of transport blocks is greater than the predetermined threshold M, the number of transport blocks about which the detection result of the error detector 620 shows no errors is compared with the predetermined threshold M1 (ST3100). When this comparison result shows that the number of transport blocks is equal to or less than the predetermined threshold M1, the detection result of the error detector 620 is regarded as including errors for all transport blocks (ST3200). Thus, using the method of carrying out stop control in consideration of the number of transport blocks, when the number of transport blocks is more than one and equal to or greater than the threshold M, by regarding a less reliable accidental error detection result as having some errors in such a way that only a small number of transport blocks are regarded as having no errors (e.g., when there are many transport blocks, only the error detection result of one transport block is decided to include no errors), it is possible to reduce omission errors by an accidental match of error detection bits. On the other hand, when the number of transport blocks with no errors is equal to or greater than the predetermined threshold M1, the process moves on to the next step.

Then, it is decided by a predetermined stop decision method whether iterative decoding should be terminated or not (ST1400).

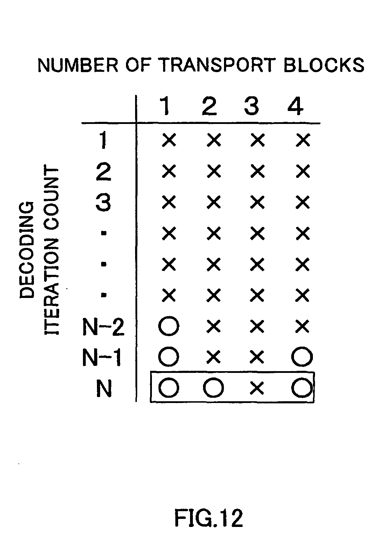

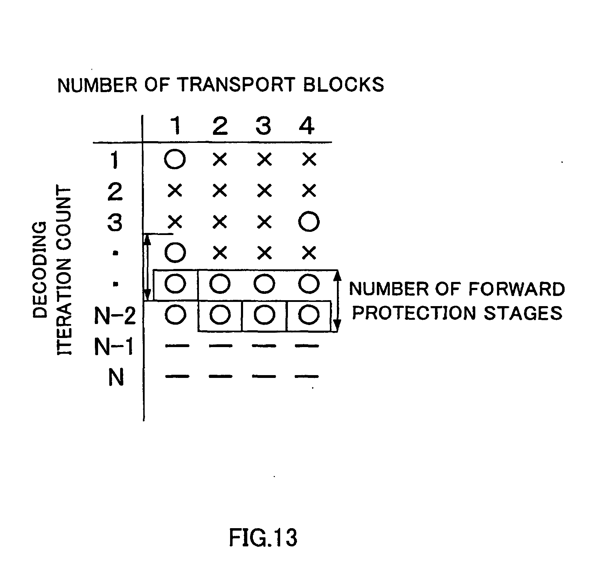

When the number of transport blocks is greater than the predetermined threshold M, any one of the following iterative decoding stop decision methods is used:
(Stop decision method 1): When the value of the counter R is equal to a predetermined maximum iteration count N, iterative decoding is terminated (see FIG.12).
(Stop decision method 2): The detection result of the error detector 620 is controlled for each transport block and iterative decoding is terminated when error detection results continue to show no errors the same number of times as the number of forward protection stages (see FIG.13).
(Stop decision method 3): An iterative decoding operation is carried out within the range of a predetermined maximum iteration count and iterative decoding is terminated when the error detection results of all transport blocks show no errors simultaneously (see FIG.8).
(Stop decision method 4): An iterative decoding operation is carried out within the range of a predetermined maximum iteration count and iterative decoding is terminated when the error detection results of all transport blocks show no errors at least once at an iteration count which is equal to or greater than a predetermined threshold (see FIG.9).
(Stop decision method 5): An iterative decoding operation is carried out within the range of a predetermined maximum iteration count and iterative decoding is terminated when the error detection results of all transport blocks show no errors simultaneously at an iteration count equal to or less than the predetermined threshold (see FIG.10A) or when the error detection results of all transport blocks show no errors at least once at an iteration count which is equal to or greater than the predetermined threshold (see FIG.10B).

Then, when iterative decoding is terminated, a decoding stop flag is set (ST1500) and when iterative decoding is not terminated, the process moves on to the next step. Then, it is decided whether the error detection result of the decoding result conforms to the termination condition or not (ST1800) and the processing is terminated when a decoding stop flag is set. When the error detection result of the decoding result does not conform to the termination condition, the maximum iteration count N is compared with the counter R (ST1900) and the processing is terminated if the counter R reaches the maximum iteration count N and the counter R is incremented (ST2000) if the counter R does not reach the maximum iteration count N and turbo decoding processing is carried out again.

On the other hand, in ST3000, if the number of transport blocks is equal to or less than the predetermined threshold M, it is decided by a stop decision method whether iterative decoding should be terminated or not (ST1600). When the number of transport blocks is equal to or less than the predetermined threshold M, any one of (stop decision method 1) to (stop decision method 5) is used as the iterative decoding stop decision method as in the case where the number of transport blocks is greater than the predetermined threshold M.

Then, when iterative decoding is terminated, a decoding stop flag is set (ST1700) and when iterative decoding is not terminated, the process moves on to the next step. The same processing as in the case where the number of transport blocks is greater than threshold M is carried out thereafter.

In this way, according to this embodiment, if error detection results show only a small number of transport blocks with no errors, all transport blocks are regarded as including errors, and therefore even if there are many transport blocks, it is possible to reduce omission errors caused by the presence of transport blocks in which error detection bits happen to match.

In this embodiment, the threshold M1 which is compared with the number of transport blocks without errors is assumed to be a fixed value, but it is also possible to set the threshold M1 dynamically as a proportion of the number of transport blocks transmitted, for example.

### (Embodiment 3)

A feature of Embodiment 3 of the present invention is that if error detection results show only a small number of transport blocks without errors, all transport blocks are regarded as including errors.

The configuration of the decoding section of this embodiment is the same as the configuration of the decoding section 600 shown in FIG.5 and explanations thereof will be omitted.

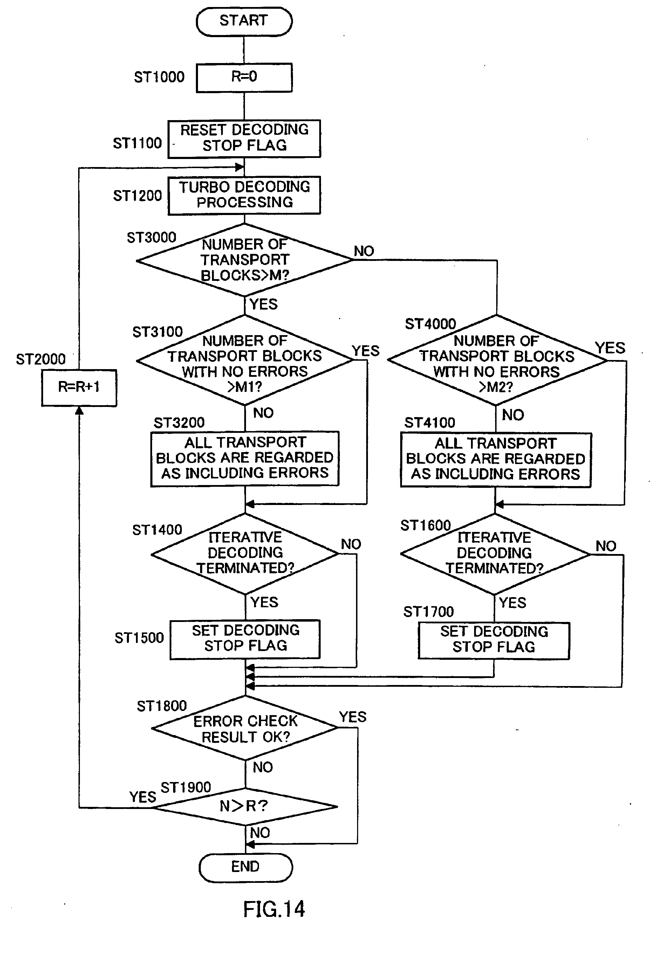

Then, a decision method of the decoding control section 630 will be explained with reference to the flow chart shown in FIG.14 and FIG.8 to FIG.10 and FIG.12. The processing shown in FIG.14 is carried out at a W-CDMA scheme TTI (Transmit Time Interval) specified as 10 ms, 20 ms, 40 ms and 80 ms according to the 3GPP, for example. Furthermore, in FIG.8 to FIG.10 and FIG.12, ○ indicates that the result of the error detector 620 includes no errors and × indicates that the result of the error detector 620 includes an error.

As shown in FIG.14, first, the counter R indicating a decoding iteration count is initialized to 0 (ST1000) and a decoding stop flag for stopping iterative decoding by the turbo decoder 610 is reset (ST1100).

Then, the decoding control section 630 outputs an instruction for performing decoding processing to the turbo decoder 610 (ST1200). Then, it is decided whether the number of transport blocks is greater than a predetermined threshold M or not (ST3000) and if the number of transport blocks is greater than the predetermined thresholdM, the number of transport blocks about which the detection result of the error detector 620 shows no errors is compared with the predetermined threshold M1 (ST3100). When this comparison result shows that the number of transport blocks is equal to or less than the predetermined threshold M1, the detection result of the error detector 620 is regarded as including errors for all transport blocks (ST3200). Thus, when the number of transport blocks is relatively large, if the number of transport blocks whose detection result shows no errors is small, all transport blocks are regarded as including errors and it is possible to suppress omission errors which may happen to be regarded as having no errors. On the other hand, when the number of transport blocks with no errors is equal to or greater than the predetermined threshold M1, the process moves on to the next step.

Then, it is decided by a predetermined stop decision method whether iterative decoding should be terminated or not (ST1400).

When the number of transport blocks is greater than a predetermined threshold M, any one of the following iterative decoding stop decision methods is used:
(Stop decision method 4): An iterative decoding operation is carried out within the range of a predetermined maximum iteration count and iterative decoding is terminated when the error detection results of all transport blocks show no errors at least once at an iteration count which is equal to or greater than a predetermined threshold (see FIG.9).
(Stop decision method 5): An iterative decoding operation is carried out within the range of a predetermined maximum iteration count and iterative decoding is terminated when the error detection results of all transport blocks show no errors simultaneously at an iteration count which is equal to or less than the predetermined threshold (see FIG.10A) or when the error detection results of all transport blocks show no errors at least once at an iteration count which is equal to or greater than the predetermined threshold (see FIG.10B).

It is also possible to use (stop decision method 1) and (stop decision method 3) shown in FIG.12 and FIG. 8, and that case corresponds to the case without ST3200 in the flow chart shown in FIG.14.

Then, when iterative decoding is terminated, a decoding stop flag is set (ST1500) and when iterative decoding is not terminated, the process moves on to the next step. Then, it is decided whether the error detection result of the decoding result conforms to the termination condition or not (ST1800) and the processing is terminated when a decoding stop flag is set. When the error detection result of the decoding result does not conform to the termination condition, the maximum iteration count N is compared with the counter R (ST1900) and the processing is terminated if the counter R reaches the maximum iteration count N, whereas the counter R is incremented (ST2000) if the counter R does not reach the maximum iteration count N, and turbo decoding processing is carried out again.

On the other hand, in ST3000, if the number of transport blocks is equal to or less than the predetermined threshold M, the number of transport blocks about which the detection results of the error detector 620 show no errors is compared with a predetermined threshold M2 (ST4000). When this comparison result shows that the number of transport blocks without errors is equal to or less than the predetermined thresholdM2, the detection results of the error detector 620 about all transport blocks are regarded as including no errors (ST4100). Unlike Embodiment 2, even when the number of transport blocks is relatively small, if the number of transport blocks whose detection results show no errors is small, all transport blocks are regarded as including no errors, making it possible to suppress omission errors which may happen to be regarded as including no errors. On the other hand, if the number of transport blocks regarded as including no errors is equal to or greater than the predetermined threshold M2, the process moves on to the next step.

Then, it is decided by a predetermined stop decision method whether iterative decoding should be terminated or not (ST1600).

When the number of transport blocks is equal to or less than the predetermined threshold M, either (stop decision method 4) or (stop decision method 5) is used as the iterative decoding stop decision method as in the case where the number of transport blocks is greater than the predetermined threshold M. Furthermore, it is also possibletouse (stop decisionmethod 1) and (stop decision method 3) shown in FIG.12 and FIG.8, but the operation in that case is equivalent to the operation without ST4100 in the flow chart shown in FIG.14.

Then, when iterative decoding is terminated, a decoding stop flag is set (ST1700) and when iterative decoding is not terminated, the process moves on to the next step. The same processing as in the case where the number of transport blocks is greater than the predetermined threshold M is carried out thereafter.

In this way, according to this embodiment, when there are only a small number of transport blocks about which error detection results show no error, all transport blocks are regarded as including errors, and therefore it is possible to reduce omission errors caused by the presence of transport blocks in which error detection bits happen to match.

In this embodiment, the threshold M1 and threshold M2 which are compared with the number of transport blocks without errors are assumed to be fixed values, but it is also possible to dynamically set them as a proportion of the number of transport blocks transmitted, for example.

Furthermore, it is also possible to combine the above described embodiments, branch processing into a case where the number of transport blocks is one and a case where the number of transport blocks is more than one according to Embodiment 1 and further carry out the processing in Embodiment 2 or Embodiment 3 when the number of transport blocks is more than one.

The error correction decoding apparatus of the present invention is applicable to a mobile terminal and base station apparatus in a radio communication system or a wired communication apparatus.

As the effect of application of the present invention, assuming in Embodiment 2, for example, that the predetermined threshold M in ST3000 was 12, the predetermined threshold M1 in ST3100 was 0.1 and (stop decision method 5) was used as the stop decision method in ST1400, a trial FTP transfer of 10 MB data was carried out 20 times from a server to a mobile station at a throughput of approximately 300 kbps. When no comparison was made with a predetermined threshold (that is, ST3000 and ST3100), a TCP checksum error occurred 4 times, but when a comparison was made with a predetermined threshold, a TCP checksum error became 0.

As described above, the present invention can reduce a processing delay time, reduce omission errors and thereby improve transmission quality.

This application is based on the Japanese Patent Application No. 2002-097969 filed on March 29, 2002, entire content of which is expressly incorporated by reference herein.

### Industrial Applicability

The present invention is applicable to an error correction decoding apparatus and error correction decoding method, and more particularly, to an error correction decoding apparatus and error correction decoding method which performs iterative decoding.

## Claims

1. An error correction decoding apparatus comprising:
an iterative decoding section that iterates error correction decoding on a coded sequence subj ected to error correction coding for predetermined transmission unit to which an error detection code is added,
an error detection section that performs error detection on the error correction decoding result for every said predetermined transmission unit according to said error detection code; and
an iteration control section that controls said iterative decoding section based on the number of said predeterminedtransmissionunitsandthedetectionresult of said error detection section.

2. The error correction decoding apparatus according to claim 1, wherein said iteration control section performs branch control for when the number of said predetermined transmission units is 1 or more than 1.

3. The error correction decoding apparatus according to claim 1, wherein when the number of said predetermined transmission units is 1, said iteration control section iterates the decoding operation of said iterative decoding section up to a predetermined maximum iteration count.

4. The error correction decoding apparatus according to claim 1, wherein when the number of said predetermined transmission units is 1, said iteration control section iterates the decoding operation of said iterative decoding section until detection results of said error detection section continue to show no errors a predetermined number of times.

5. The error correction decoding apparatus according to claim 1, wherein when the number of said predetermined transmission units is 2 or more and the number of transmission units about which detection results of said error detection section show no errors is equal to or less than a predetermined threshold, said iteration control section regards all detection results of said error detection section as including errors.

6. The error correction decoding apparatus according to claim 1, wherein when the number of said predetermined transmission units is 2 or more and the number of transmission units about which detection results of said error detection section show no errors is equal to or less than a predetermined threshold according to the number of said predetermined transmission units, said iteration control section regards all detection results of said error detection section as including errors.

7. The error correction decoding apparatus according to claim 1, wherein said iteration control section comprises a comparison section that compares the number of said predetermined transmission units with a first threshold, and when the comparison result shows that the number of said predetermined transmission units is equal to or greater than the first threshold and the number of transmission units about which detection results of said error detection section show no errors is equal to or less than a second threshold, all detection results of said error detection section are regarded as including errors.

8. The error correction decoding apparatus according to claim 1, wherein said iteration control section comprises a comparison section that compares the number of said predetermined transmission units with a first threshold, and when the comparison result shows that the number of said predetermined transmission units is equal to or greater than the first threshold and the number of transmission units about which detection results of said error detection section show no errors is equal to or less than a second threshold according to the number of said predetermined transmission units, all detection results of said error detection section are regarded as including errors.

9. The error correction decoding apparatus according to claim 1, wherein said iteration control section comprises a comparison section that compares the number of said predetermined transmission units with a first threshold, and when the comparison result shows that the number of said predetermined transmission units is equal to or less than the first threshold and equal to or greater than 2 and detection results of said error detection section continue to show no errors a predetermined number of times within a predetermined maximum iterative decoding count, said iterative decoding section is stopped.

10. A communication base station apparatus comprising the error correction decoding apparatus according to claim 1.

11. A communication terminal apparatus comprising the error correction decoding apparatus according to claim 1.

12. An error correction decoding method for iterating error correction decoding on a coded sequence subjected to error correction coding for predetermined transmission unit to which an error detection code is added, comprising:
a step of performing error detection on the error correction decoding result for every said predetermined transmission unit according to said error detection code; and
a step of controlling iteration of error correction decoding based on the number of said predetermined transmission units and error detection result.
